**Europäisches Patentamt**

(19) **European Patent Office**

**Office européen des brevets**

(11) Veröffentlichungsnummer: **0 029 480**
**B1**

(12) # EUROPÄISCHE PATENTSCHRIFT

(45) Veröffentlichungstag der Patentschrift:
**22.02.84**

(51) Int. Cl.³: **H 03 K 19/013**, H 03 K 19/082

(21) Anmeldenummer: **80103972.8**

(22) Anmeldetag: **10.07.80**

(54) **Emitterfolger-Logikschaltung.**

(30) Priorität: **23.11.79 US 97013**

(43) Veröffentlichungstag der Anmeldung:
**03.06.81 Patentblatt 81/22**

(45) Bekanntmachung des Hinweises auf die Patenterteilung:
**22.02.84 Patentblatt 84/8**

(84) Benannte Vertragsstaaten:
**DE FR GB**

(56) Entgegenhaltungen:
**US - A - 3 077 545**
**US - A - 3 265 906**

**REVIEW OF THE ELECTRICAL COMMUNICATION LABORATORIES, Band 26, Nr. 9-10, September-Oktober 1978 Tokyo JP MUKAI und KATAOKA: "Master Slice ECL LSI" Seiten 1325-1338**
**IBM TECHNICAL DISCLOSURE BULLETIN, Band 18, Nr. 6, November 1975 New York US PRILIK: "High-Speed Voltage Current Pulser", Seiten 1930-1932**

(73) Patentinhaber: **International Business Machines Corporation, Old Orchard Road, Armonk, N.Y. 10504 (US)**

(72) Erfinder: **Cavaliere, Joseph Richard, Bykehull Road, Hopewell Junction New York 12533 (US)**
Erfinder: **Henle, Robert Athanasius, Sunset Trail, Clinton Corners New York 12514 (US)**
Erfinder: **Konian, Richard Robert, 49 Brookland Farms Rd., Poughkeepsie New York 12601 (US)**
Erfinder: **Walsh, James Leo, 23 South Drive, Hyde Park New York 12538 (US)**

(74) Vertreter: **Gaugel, Heinz, Dipl.-Ing., Schönaicher Strasse 220, D-7030 Böblingen (DE)**

## Emitterfolger-Logikschaltung

Die Erfindung bezieht sich auf Emitterfolger-Logikschaltungen mit in Serie geschaltetem, komplementären Transistorpaar, insbesondere auf Schaltungen, die durch die Verstärkung Eins, niedrige Verlustleistung und hohe Ansprechgeschwindigkeit auf ansteigende und abfallende Flanken der zugeführten Eingangssignale charakterisiert sind und bei denen keine Pegelverschiebungen auftreten.

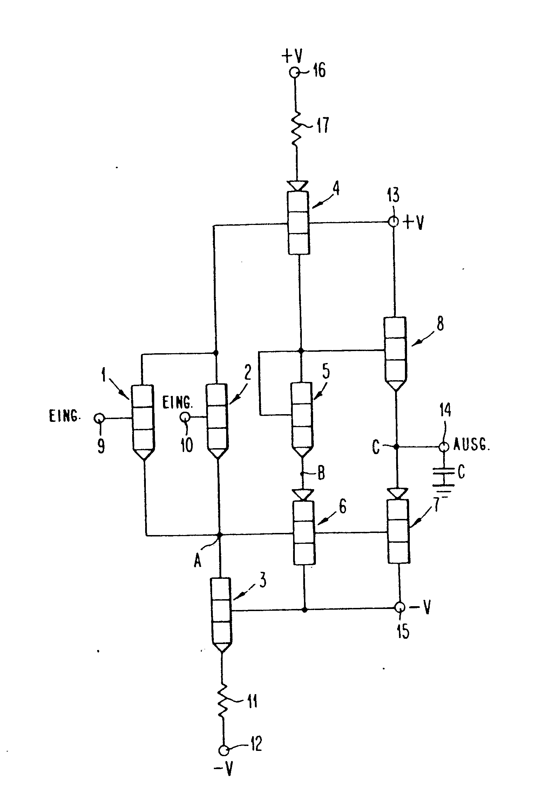

Es sind ausgangsseitig kapazitiv belastete Emitterfolger bekannt, deren wesentliches Merkmal ein komplementäres Transistorpaar ist. Eine entsprechende Schaltung ist in dem Buch »Pulse, Digital and Switching Waveforms«, von J. Millmann und H. Taub, McGraw Hill, 1965, auf Seite 304 in Verbindung mit der Fig. 8—36 beschrieben. Diese Schaltung liefert ein Ausgangssignal, dessen ansteigenden und abfallenden Flanken mit vergleichbarer Geschwindigkeit den entsprechenden ansteigenden und abfallenden Flanken des zugeführten Eingangssignals folgen. Es ist jedoch festzustellen, daß bei diesem bekannten Emitterfolger die Basen der in Serie geschalteten, komplementären Transistoren von ein und demselben Eingangssignal gesteuert werden, dessen Amplituden also jeden der beiden Transistoren ein- und ausschalten.

Diese Betriebsweise erfordert relativ große Amplituden des Eingangssignals, die mindestens gleich der Summe der Basis-Emitterspannungen ($V_{be}$) für das Durchschalten des Emitter-Basisüberganges der beiden Transistoren sind und damit auch eine hohe Verlustleistung mit sich bringen.

Ein weiterer Nachteil des bekannten Emitterfolgers liegt darin, daß seine Verstärkung geringer als Eins ist und daß damit die auftretende Signalabschwächungen durch Hilfstreiber ausgeglichen werden müssen, um mehrere Emitterfolger in Kaskade schalten zu können. Schließlich bewirkt der bekannte Emitterfolger eine Pegelverschiebung des Signals zwischen Eingang und Ausgang um mindestens eine Basis-Emitterspannung, was zur Folge hat, daß zusätzliche Pegelverschiebeschaltungen zum Ausgleich dieser Pegelverschiebung eingesetzt werden müssen.

Hier will die Erfindung Abhilfe schaffen. Die Erfindung, wie sie in den Ansprüchen gekennzeichnet ist, löst die Aufgabe, eine Emitter-Logikschaltung mit in Serie geschaltetem, komplementäre Transistorpaar zu schaffen, bei dem durch schaltungsmäßige Maßnahmen unerwünschte Pegelverschiebungen verhindert, eine Verstärkung Eins erzielt und gleichzeitig die Eingangssignalamplituden vermindert werden, was insbesondere auch zu optimalen Ansprechgeschwindigkeiten führt.

Die hohe Ansprechgeschwindigkeit, die Verstärkung Eins und die fehlende Pegelverschiebung wird im wesentlichen dadurch erreicht, daß zwei Stromquellen, mehrere Eingangstransistoren und eine Schaltung von zwei Paaren komplementärer Transistoren eingesetzt werden. Diese Schaltung liefert gleich schnelle Ansprechzeiten auf die ansteigenden und abfallende Flanken des Eingangssignals. Eine der Stromquellen treibt die Eingangstransistoren, während die andere Stromquelle mit dem eingangsseitigen Transistorpaar verbunden ist. Aufgrund der Stromquellen entspricht das Signal an den Emittern der Transistoren dem Signal an den Basen, was eine Verstärkung Eins ergibt.

Im folgenden wird die Erfindung anhand eines in der Zeichnung dargestellten Ausführungsbeispiels näher erläutert.

Dargestellt ist in der Zeichnung das Schaltbild einer erfindungsgemäßen Emitterfolger-Logikschaltung.

Im in der Zeichnung dargestellten Ausführungsbeispiel sind die Kollektor-Emitter Strecken zweier NPN-Eingangstransistoren in konventioneller ODER-Verknüpfung parallel geschaltet. Die Basen der beiden Transistoren sind mit den Eingangsanschlüssen 9 und 10 verbunden, über die die Eingangssignale zugeführt werden. Die miteinander verbundenen Emitter (Knoten A) der beiden Eingangstransistoren 1 und 2 sind mit dem Kollektor eines NPN-Transistors 3 verbunden. Der Emitter des Transistors 3 ist über einen Widerstand 11 an den Anschluß 12 einer negativen Spannungsquelle geführt. Die verbundenen Kollektoren der Eingangstransistoren 1 und 2 und die Basis eines PNP-Transistors 4 sind mit dem Anschluß 13 einer positiven Spannungsquelle verbunden.

Ein Paar komplementärer Transistoren 5 und 6 ist mit den Emittern verbunden (Knoten B). Die Emitter eines weiteren Paares komplementärer Transistoren 7 und 8 sind ebenfalls miteinander verbunden (Knoten C) und außerdem an den Ausgangsanschluß 14 geführt, an dem eine kapazitive Last C liegt. Vorzugsweise wählt man als NPN- und PNP-Transistoren solche mit etwa gleicher Basis-Emitterspannung ($V_{be}$) und Transit-Frequenz ($f_t$), so daß die Gleichstrom-Pegelverschiebung zwischen den Eingangsanschlüssen 9 und 10 und dem Ausgangsanschluß 14 auf ein Minimum reduziert wird, und daß das Ausgangssignal am Ausgangsanschluß 14 den Eingangssignalen an den Eingangsanschlüssen 9 und 10 mit nahezu gleicher Geschwindigkeit für ansteigende und abfallende Signalflanke folgt.

Die Basis des Transistors 3 und die Kollektoren der Transistoren 6 und 7 sind mit dem Anschluß 15 einer negativen Spannungsquelle verbunden. Der durch eine Verbindung zwischen Basis und Kollektor als Diode geschaltete Transistor 5 ist mit dem diese Verbindung bildenden Knoten über den Emitter-Kollektorpfad des PNP-Transistors 4 und einen Widerstand 17 an den Anschluß 16 einer positiven Spannungsquelle geführt. Die Transistoren 3 und 4 bilden mit den jeweils in ihren Emitterkreisen angeordneten Widerständen 11 und 17 jeweils eine Konstantstromquelle für die Eingangstransistoren 1 und 2 und für das Transistorpaar 5 und 6.

Im Betrieb wird die zwischen den Basen der Transistoren 5 und 6 erzeugte Gleichspannungsverschiebung von zwei Basis-Emitterspannungen der entsprechenden, zwischen den Basen der Transistoren 7 und 8 erforderlichen Verschiebung angeglichen. Deshalb wird die hohe Spannung an den Emittern (Knoten A) der Eingangstransistoren 1 und 2 so eingestellt, daß die Transistoren 7 und 8 gleichzeitig an ihrem Schwellwert für Leitfähigkeit liegen. Nimmt man also beispielsweise an, am Eingangsanschluß 9 liege der obere und am Eingangsanschluß 10 der untere Signalpegel und das Signal am Anschluß 9 beginne nun abzufallen, was einen entsprechenden Pegelabfall im Knoten A bewirkt, so beginnt Transistor 7 unmittelbar zu leiten, während Transistor 8 unmittelbar zu leiten aufhört. Zur Auslösung dieses Vorganges genügt bereits ein Bruchteil einer Basis-Emitterspannung. Daraus erklärt sich im Vergleich zu bekannten Emitterfolgern große Ansprechgeschwindigkeit für die abfallende Signalflanke. Entsprechendes gilt, wenn an beiden Eingangsanschlüssen 9 und 10 der untere Signalpegel anliegt und am Anschluß 9 ein Eingangssignal mit ansteigender Signalflanke auftritt. Transistor 8 beginnt sofort zu leiten, während Transistor 7 sofort gesperrt wird.

Die aus dem Transistor 3 und dem Widerstand 11 bestehende Konstantstromquelle, die zusammen mit den Eingangstransistoren 1 und 2 ebenfalls einen Emitterfolger bildet, bewirkt, daß dieser Emitterfolger die Verstärkung 1 aufweist. Entsprechend ist die Konstantstromquelle bestehend aus Transistor 4 und Widerstand 17 dafür verantwortlich, daß der aus dem Transistor 5 und dem Transistor 6 bestehende Emitterfolger ebenfalls die Verstärkung Eins aufweist. Das bedeutet, daß das Potential im Knoten A dem Potential an den Eingangsanschlüssen 9 und 10 mit der Verstärkung Eins folgt. Das Potential im Knoten B folgt dem Potential des Punktes A ebenfalls mit der Verstärkung Eins. Durch die Anordnung der Transistoren 5, 6, 7 und 8 und deren angeglichene Basis-Emitterspannungen folgt das Potential im Knoten C dem Potential im Knoten B ebenfalls mit der Verstärkung Eins.

Die zwischen Basis und Emitter des Transistors 1 oder 2 auftretende Gleichspannungsverschiebung um eine Basis-Emitterspannung wird durch die gleiche aber entgegengesetzte Verschiebung um eine Basis-Emitterspannung aufgehoben, die zwischen Emitter und Basis des Transistors 6 auftritt. Da, wie bereits ausgeführt, das Potential im Knoten C dem Potential im Knoten B angeglichen ist, tritt zwischen dem Ausgangsanschluß 14 und den Eingangsanschlüssen 9 oder 10 keine Gleichspannungsverschiebung auf.

Typische Schaltungsparameter für die in der Zeichnung dargestellte Emitterfolger-Logikschaltung sind: am Anschluß 12 −2 V, am Anschluß 13 +0,8 V, am Anschluß 15 −0,8 V, am Anschluß 16 +2 V in Verbindung mit Widerständen 11 und 17 von jeweils 1 K Ω.

## Patentansprüche

1. Emitterfolger-Logikschaltung enthaltend ein über ihre Kollektoren zwischen einer ersten und einer zweiten Spannungsquelle (13, 15) in Serie geschaltetes Transistorpaar aus einem ersten (8) und einem zu diesen komplementären zweiten Transistor (7), deren verbundene Emitter gleichzeitig den Ausgang (14) bilden, dadurch gekennzeichnet, daß ein dem zweiten Transistor (7) entsprechender, jeweils über Kollektor und Basis mit diesem verbundener dritter Transistor (6) vorgesehen ist, dessen Emitter über eine der Basis-Emitterstrecke des ersten Transistors entsprechende Diodenstrecke (5) mit der Basis des ersten Transistors (8) und mit einer ersten Stromquelle (4, 17) verbunden ist, und daß mehrere mit ihren Basen die Eingänge (9, 10) bildende Eingangstransistoren (1, 2) des Typs des ersten Transistors (8) vorgesehen sind, deren Emitter gemeinsam an die verbundenen Basen des zweiten und dritten Transistors (7, 6) und an eine zweite Stromquelle (3, 11) geführt sind und deren Kollektoren an die erste Spannungsquelle (13) angeschlossen sind.

2. Emitterfolger-Logikschaltung nach Anspruch 1, dadurch gekennzeichnet, daß die erste und zweite Stromquelle jeweils aus einem Transistor (3, 4) besteht, dessen Emitter über einen Widerstand (11, 17) mit einer Spannungsquelle (12, 16) verbunden ist.

3. Emitterfolger-Logikschaltung nach Anspruch 1, dadurch gekennzeichnet, daß Transistoren mit etwa gleich großer Basis-Emitterspannung ($V_{be}$) gewählt sind.

4. Emitterfolger-Logikschaltung nach Anspruch 1, dadurch gekennzeichnet, daß Transistoren mit etwa gleich großer Transit-Frequenz ($f_t$) gewählt sind.

5. Emitterfolger-Logikschaltung nach Anspruch 1, dadurch gekennzeichnet, daß Transistoren mit etwa gleich großer Basis-Emitterspannung ($V_{be}$) und etwa gleich großer Transit-Frequenz ($f_t$) gewählt sind.

## Claims

1. Emitter follower logic circuit, comprising a pair of transistors composed of a first (8) and a second transistor (7) complementary to the former, said transistors being arranged in series between a first and a second voltage source, and the connected emitters of said circuit representing at the same time the output terminal (14), characterized in that a third transistor (6) corresponding to the second transistor (7) and being respectively connected thereto via collector and base is provided whose emitter, via a diode path (5) corresponding to the base-emitter path of the first transistor, is connected to the base of the first transistor (8) and to a first current source (4, 17), and that several input transistors (1, 2) of the type of the first transistor (8) are provided who with their bases form the inputs (9, 10), and whose emitters are applied jointly to the connected bases of the second and third transistor (7, 6) and to a second current source (3, 11), and whose collectors are connected to the first voltage source (13).

2. Emitter follower logic circuit as claimed in claim 1, characterized in that the first and second current source respectively consists of a transistor (3, 4) whose emitter is connected via a resistor (11, 17) to a voltage source (12, 16).

3. Emitter follower logic circuit as claimed in claim 1, characterized in that the base emitter voltages ($V_{be}$) of the transistors are approximately equal to each other.

4. Emitter follower logic circuit as claimed in claim 1, characterized in that the transit frequencies ($f_t$) of the transistors are approximately equal to each other.

5. Emitter follower logic circuit as claimed in claim 1, characterized in that transistors are selected whose base emitter voltages ($V_{be}$) and transit frequencies ($f_t$) are approximately equal to each other.

**Revendications**

1. Circuit logique émetteur-suiveur comportant une première paire de transistors, montés en série par leur collecteur entre une première (13) et une seconde source de tension (15), comportant un premier transistor (8) et un deuxième transistor (7) de type complémentaire dudit premier transistor, et dont les émetteurs reliés entre eux constituent en même temps la sortie (14), caractérisé en ce qu'il est prévu un troisième transistor (6) correspondant audit deuxième transistor (7) auquel il est relié respectivement par son collecteur et sa base, et dont l'émetteur est relié à la base dudit premier transistor (8) et à une première source de courant (4, 17) à travers une diode (5) correspondant au trajet base-émetteur dudit premier transistor, et qu'il est prévu plusieurs transistors d'entrée (1, 2) du type dudit premier transistor (8) dont les bases constituent des entrées (9, 10), dont les émetteurs sont, de façon commune, reliés aux bases, reliées entre elles des deuxième et troisième transistors (7, 6) et à une deuxième source de courant (3, 11) et dont les collecteurs sont reliés à ladite première source de tension (13).

2. Circuit logique émetteur-suiveur selon la revendication 1, caractérisé en ce que lesdites première et deuxième sources de courant sont constituées respectivement par des transistors (3, 4) dont les émetteurs sont respectivement reliés à travers des résistances (11, 17) à des sources de tension (12, 16).

3. Circuit logique émetteur-suiveur selon la revendication 1, caractérisé en ce qu'en choisit des transistors ayant une tension base-émetteur ($V_{be}$) à peu près équivalente.

4. Circuit logique émetteur-suiveur selon la revendication 1, caractérisé en ce qu'on choisit des transistors ayant une fréquence de transit à peu près équivalente ($f_t$).

5. Circuit logique émetteur-suiveur selon la revendication 1, caractérisé en ce qu'on choisit des transistors dont les tensions base-émetteur ($V_{be}$) et les fréquences de transit ($f_t$) respectives sont à peu près équivalentes.